# EUROPEAN PATENT SPECIFICATION

(11) **EP 1 254 460 B1**
(45) Date of publication and mention of the grant of the patent: **28.03.2007**
(21) Application number: 01923557.1
(22) Date of filing: 31.01.2001
(51) Int. Cl.: G11C 11/00

(54) **1T FLASH MEMORY RECOVERY SCHEME FOR OVER-ERASURE**
UBERLÖSCHKORREKTURVERFAHREN FUR 1T FLASHSPEICHER
SCHEMA DE RECUPERATION D'UNE MEMOIRE FLASH A UN TRANSISTOR, A PARTIR D'UN SUREFFACEMENT

(30) Priority: 31.01.2000 US 179234 P; 29.01.2001 US 772220
(43) Date of publication of application: 06.11.2002
(73) Proprietor: Infineon Technologies AG, 81669 München (DE)
(72) Inventor: SHUM, Danny, Austin, TX 78759 (US); TEMPEL, Georg, 1933 Sterrebeek (BE); LUDWIG, Christoph, 01465 Langebrueck (DE)
(74) Representative: Patentanwälte Westphal, Mussgnug & Partner
(86) International application number: PCT/EP2001/001034
(87) International publication number: WO 2001/056035

(56) References cited:
- US-A- 5 742 541
- US-A- 5 978 277
- JEN-TAI HSU ET AL: "COMPARISON OF OVER ERASE SUSCEPTIBILITY AND CYCLING RELIABILITY BETWEEN CHANNEL ERASE AND BITLINE ERASE IN FLASH EEPROM" EXTENDED ABSTRACTS OF THE INTERNATIONAL CONFERENCE ON SOLID STATE DEVICES AND MATERIALS, JAPAN SOCIETY OF APPLIED PHYSICS. TOKYO, JA, 21 August 1995 (1995-08-21), pages 64-66, XP000544565
- BERGEMONT A ET AL: "NOR VIRTUAL GROUND (NVG)- A NEW SCALING CONCEPT FOR VERY HIGH DENSITY FLASH EEPROM AND ITS IMPLEMENTATION IN A 0.5 UM PROCESS" PROCEEDINGS OF THE INTERNATIONAL ELECTRON DEVICES MEETING. WASHINGTON, DEC. 5 - 8, 1993, NEW YORK, IEEE, US, 5 December 1993 (1993-12-05), pages 15-18, XP000490876 ISBN: 0-7803-1451-4

## Description

### Background of the Invention

Electrical erasure of flash memories for one transistor flash memory cells are subject to erase threshold control problems. Electrical erase can continue beyond neutral level placing a net positive charge on the floating gate resulting in a net negative threshold voltage. The negative threshold voltage can electrically short out a column of memory or increase leakage current of the same column, and result in reading false logic ones from the column during a read operation even if the selected cell is in a logic "0" state. Other cells may not be able to be programmed due to the current draw caused by an over-erased cell. The threshold voltage of the cell may change after electrical erasure due to coupling ratio and tunneling probability yielding a much wider threshold voltage distribution. Conventional flash memories have addressed this problem using several techniques: For instance, the verified-erase method see, V.N. Kynett et al, "A 90 -ns One-Million Erase/Program Cycle 1-Mbit Flash Memory, " IEEE J. Solid-State Circuits, vol. SC-24, no.10, pp.1238-1243, 1989, results in a complicated erase algorithm and pre-programming of cells is required in case repeated cell programming results in leaky cells. The verified erase method controls the threshold voltage level of cells. However, the distribution of threshold voltages of all cells in a memory is usually Gaussian running typically from 4 volts down to 0 volts. Consequently, the time it takes to erase a bit can vary greatly among the cells. Reducing the spread of voltage of the distribution of threshold voltages provides a more overall uniform erase threshold voltage. The two step erase procedure addresses the need to shrink the spread of the erased Vt distribution. A flash EEPROM array is erased and a threshold voltage distribution of the erased flash EEPROM cells is converged to within a predetermined voltage range. In the first step, a conventional "edge" or "channel" electrically bulk erase procedure is accomplished by applying a high voltage to the control gate of the cell. Erase occurs according to a Fowler-Nordheim tunneling mechanism causing electrons to tunnel from the floating gate to the source (edge erase) or body (channel erase), resulting in cells with a relatively low threshold voltage,. In the second step, the cell is programmed by applying a high voltage to the control gate (using Fowler-Nordheim tunneling) to converge the erased threshold voltage distribution of the array to within the predetermined voltage range. The drain, source and substrate of the 1T flash transistor are grounded or presented with no bias across those regions. This grounded or non-biasing approach allows chip-wise or block-wise memory recovery from over erasure, but not column-wise recovery. The erasing method described in prior art document US-A-5 742 541 is subjected to the same restriction. Another method, the self-convergence erasing scheme is typically accomplished using channel hot carrier injection. (see S. Yamada et al., "A Self-Convergence Erasing Scheme for a Simple Stacked gate Flash EEPROM," IEEE IEDM Tech. Dig., pp. 307-310, 1991. and K. Yoshikawa et al, "Comparison of Current Flash EEPROM Erasing Methods: Stability and How to Control," IEEE IEDM Tech. Dig., p. 595. 1992). However, this is undesirable due to high current requirements.

### Brief Description of the Drawings

Figure 1 illustrates a transistor, representative of an EEPROM cell from a column of transistors selected for a recovery step with control gate electrode **G**, floating gate **FG**, bitline **BL**, source region **S**, and body region b.
Figure 2 illustrates a schematic drawing of two columns of EEPROM flash memory cells from an array of memory cells.
Figure 3 shows a schematic drawing of a memory cell from an unselected column selected for a recovery step.

Reference numbers and figures have been carried forward.

### Detailed Description of the Invention

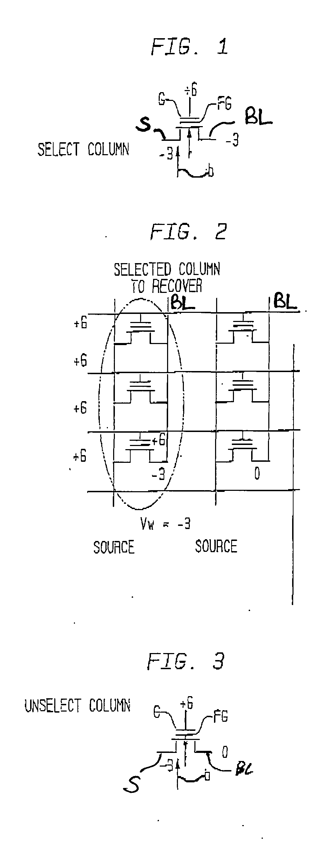

The recovery from over-erasure scheme according to the invention is accomplished by using a 1 transistor (1T) electrically- erasable programmable read only memory (EEPROM). Figure 1 illustrates such a transistor, representative of an EEPROM cell from a column of transistors selected for a recovery step with control gate **G.** floating gate **FG**, bitline **BL**, source region **S**, and body region **b**. In connection with erasing a column of memory, the first step, for the case of an enhancement mode, n-channel transistor, gate **G** is brought to a strong negative high logic level, e.g.-6 volts, while the source region, body and bitline (connected to the drain of the transistor) are left floating. Erasure is accomplished from the floating gate to the channel region of the transistor. To compensate for over-erasure, in order to recover the erased correct state for a transistor, gate **G** is brought to a strong high logic level, e.g. +6 volts while bitline **BL** and body region **b** are brought to a low level, e.g. -3 volts. The source region is left floating. Programming of the EEPROM cell is accomplished in a similar way, but with the bitline carrying the proper logic voltage level to be programmed into the cell.

Figure 2 illustrates a schematic drawing of two columns of EEPROM flash memory cells from an array of memory cells. In order to erase and recover from over erasure, a column of memory cells, the two step process described in the paragraph above is performed on the memory cells in a selected column. Unselected columns are biased according to the bias of a selected cell except that the bitline is raised in voltage. For instance, with reference to figure 3 which shows a schematic drawing of a memory cell from an unselected column, gate **G** is brought high, e.g. 6 volts, body b is at -3 volts, the source region is left floating and bitline BL is grounded (0 volts).

The flash memory recovery scheme can be applied chip-wise to all cells of the memory. In this instance, all cells are erased according to the afore described first step and all cells are biased according to the bias of a selected column as shown in figure 1.

The 2 step-recovery scheme of the invention uses a uniform electric potential across the tunnel oxide. Further the method allows low power with no GIDL leakage current , bulk mode and ensures a stable VT shift over time. The foregoing description is easily applied to p-channel devices by a change in polarity with floating nodes kept floating.

The invention can be implemented as an integrated circuit according to well known semiconductor fabrication methods.

P-channel EEPROMs according to the invention will be programmed with reverse polarities to those discussed, with supply voltage levels being substituted for ground.

## Claims

1. A method of erasing an electrically erasable programmable read-only memory array including a plurality of one transistor flash memory cells arranged in columns comprising:
a. placing a first voltage level on the control gates (G) of said plurality of one transistor flash memory cells;
b. floating the voltage levels on the drain regions (BL) and source (S) regions of said plurality of one transistor flash memory cells; and ensuring the recovery of a correct erased state of one transistor flash memory cells of a selected column of said plurality of one transistor flash memory cells by:
c. placing a voltage on said control gates (G) of said plurality of one transistor flash memory cells which is of reversed polarity to that placed on said control gates (G) in step a;
d. placing a voltage (Vw) on the drain regions (BL) and on the body regions (b) of said plurality of one transistor flash memory cells which is of a lesser absolute value magnitude and of a reversed polarity to that placed on said control gates (G) in step c;
**characterized by**
e. floating the source regions (S) of said plurality of one transistor flash memory cells during said recovery; and
f. raising a voltage level on the drain regions (BL) of the one transistor flash memory cells of unselected columns during said recovery.

## Patentansprüche

1. Verfahren zum Löschen eines elektrisch löschbaren programmierbaren Festwertspeicherarrays einschließlich mehrerer 1-Transistor-Flash-Speicherzellen, in Spalten angeordnet, umfassend:
a. Anlegen eines ersten Spannungspegels an die Steuergateelektroden (G) der mehreren 1-Transistor-Flash-Speicherzellen;
b. Potentialfreimachen der Spannungspegel an den Draingebieten (BL) und Source-(S)-Gebieten der mehreren 1-Transistor-Flash-Speicherzellen und Sicherstellen der Wiederherstellung eines korrekten gelöschten Zustands von 1-Transistor-Flash-Speicherzellen einer ausgewählten Spalte der mehreren 1-Transistor-Flash-Speicherzellen durch:
c. Anlegen einer Spannung an die Steuergateelektroden (G) der mehreren 1-Transistor-Flash-Speicherzellen, die von umgekehrter Polarität zu der in Schritt a an die Steuergateelektroden (G) angelegten ist;
d. Anlegen einer Spannung (Vw) an die Draingebiete (BL) und an die Körpergebiete (b) der mehreren 1-Transistor-Flash-Speicherzellen, die von einer kleineren Absolutwertgröße und von umgekehrter Polarität zu der in Schritt c an die Steuergateelektroden (G) angelegten ist;
**gekennzeichnet durch**
e. Potentialfreimachen der Sourcegebiete (S) der mehreren 1-Transistor-Flash-Speicherzellen während der Wiederherstellung und
f. Anheben eines Spannungspegels an den Draingebieten (BL) der 1-Transistor-Flash-Speicherzellen von nichtausgewählten Spalten während der Wiederherstellung.

## Revendications

1. Procédé d'effacement d'un réseau de mémoires mortes programmables effaçables électriquement, comprenant une pluralité de cellules de mémoire flash à un transistor disposés en colonnes, comprenant les opérations consistant à :
a) appliquer un premier niveau de tension sur les grilles de commande (G) de la pluralité de cellules de mémoire flash à un transistor,
b) laisser flotter les niveaux de tension sur les zones de drain (LB) et les zones de source (S) de la pluralité de cellules de mémoire flash à un transistor; et assurer la récupération d'un état effacé correct des cellules de mémoire flash à un transistor d'une colonne sélectionnée de la pluralité de cellules de mémoire flash à un transistor, en
c) appliquant, sur les grilles de commande (G) de la pluralité de cellules de mémoire flash à un transistor, une tension de polarité inverse de celle appliquée sur les grilles de commande (G) dans l'étape a),
d) appliquant, sur les zones de drain (LB) et sur les zones de corps (c) de la pluralité de cellules de mémoire flash à un transistor, une tension (Vw) de valeur absolue inférieure et de polarité inversée par rapport à celles de la tension appliquée sur les grilles de commande (G) dans l'étape c),
**caractérisé en ce que**
e) on laisse flotter les zones de source (S) de la pluralité de cellules de mémoire flash à un transistor pendant la récupération, et
f) on augmente le niveau de tension sur les zones de drain (LB) des cellules de mémoire flash à un transistor des colonnes non sélectionnées, pendant la récupération.
